# FASCICULE DE BREVET EUROPEEN

(11) **EP 0 279 755 B1**
(45) Date de publication et mention de la délivrance du brevet: **27.01.1993**
(21) Numéro de dépôt: 88420047.8
(22) Date de dépôt: 17.02.1988
(51) Int. Cl.: H04N 5/53

(54) **Dispositif de commande automatique de gain de signaux video**
Automatische Verstärkungsregelungseinrichtung für Videosignale
Device for the automatic gain control of video signals

(30) Priorité: 20.02.1987 FR 8702206
(43) Date de publication de la demande: 24.08.1988
(73) Titulaire: SGS-THOMSON MICROELECTRONICS S.A., 75016 Paris (FR)
(72) Inventeur: Douziech, Patrick, D-7730 VS Villingen (DE); Berger, Philippe, D-7730 VS Villingen (DE)
(74) Mandataire: de Beaumont, Michel

(56) Documents cités:
- EP-A- 0 067 585
- EP-A- 0 104 817
- GB-A- 2 054 993
- IEEE TRANSACTIONS ON CONSUMER ELECTRONICS, vol. CE-30, no. 3, août 1984, pages 382-389, IEEE, New York, US; K.-H. REHFELDT: "A multistandard chip set for VHS VCRS"
- ELECTRONIC ENGINEERING, vol. 56, no. 686, février 1984, page 32, Londres, GB; C.J.D. CATTO: "Video AGC reacts at TV field rate"
- PATENT ABSTRACTS OF JAPAN, vol. 9, no. 185 (E-332)[1908], 31 juillet 1985; & JP-A-60 53 384 (HOUEI K.K.) 27-03-1985
- PATENT ABSTRACTS OF JAPAN, vol. 7, no. 222 (E-201)[1367], 4 octobre 1983; & JP-A-58 111 587 (HITACHI SEISAKUSHO K.K.) 02-07-1983

## Description

La présente invention concerne un dispositif de commande automatique de gain de signaux vidéo pour circuits intégrés.

Le signal vidéo de sortie de diverses sources de signaux vidéo, qu'il s'agisse d'un récepteur de télévision, d'un micro-ordinateur ou d'un vidéodisque, présente une dispersion sur sa valeur crête à crête. En conséquence, le périphérique qui utilise ce signal vidéo, par exemple un magnétoscope pour le récepteur de télévision, doit comporter un dispositif de commande automatique de gain afin de réduire cette dispersion d'amplitude.

Les dispositifs de commande automatique de gain classiquement utilisés jusqu'à présent sont des systèmes bouclés analogiques qui procédent à une comparaison de la valeur crête ou quasi crête du signal à une référence. De tels dispositifs sont choisis de sorte qu'ils présentent une constante de temps pour modifier le gain suffisamment longue, pouvant durer pendant plusieurs lignes de façon que le signal vidéo ne soit pas déformé lors des modifications du gain. Or, pour cela on utilise généralement des condensateurs de capacité importante qui ne sont donc pas intégrables. Il est par conséquent nécessaire de rajouter un condensateur à l'extérieur du circuit intégré et de prévoir une borne de connexion supplémentaire à cet effet. Cependant lorsque le contenu de l'image change rapidement, il y a des risques de distorsion et de suroscillation. Il faut donc très souvent pour améliorer la qualité de l'image avoir une constante de temps plus courte dans le cas de la réduction du gain que la constante de temps utilisée pour l'augmentation du gain, ce qui conduit à l'utilisation d'un circuit extérieur plus complexe.

La présente invention a pour but de remédier à ces problèmes. Elle concerne un dispositif de commande automatique de gain de signaux vidéo qui ne comporte pas de condensateur externe au circuit intégré pour obtenir les constantes de temps désirées, ce qui a pour premier avantage de libérer une borne de connexion du circuit intégré.

Le dispositif selon l'invention présente une constante de temps différente selon que l'on est en diminution du gain ou en augmentation du gain. Les diminutions de gain se font avec une constante de temps courte fonction d'un signal d'horloge présent dans le circuit et les augmentations se font à la fréquence trame pendant les retours trame. On supprime ainsi les suroscillations de la boucle et les risques de distorsion de l'image.

L'invention a donc pour objet un dispositif de commande automatique de gain de signaux vidéo conforme à la revendication 1.

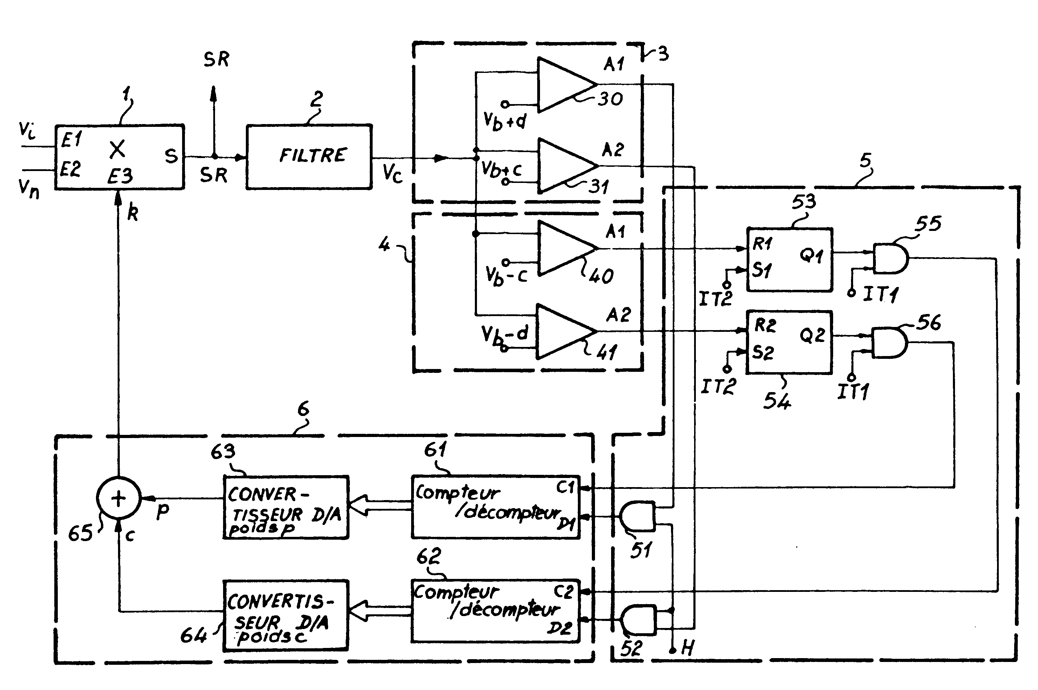

L'invention sera mieux comprise à l'aide de la description faite en regard de la figure annexée qui représente un schéma de réalisation du dispositif de commande automatique de gain selon l'invention.

Le dispositif de réglage de gain permet de normaliser les signaux vidéo des diverses sources telles que tuner, caméra, magnétoscope, micro-ordinateur. Le dispositif selon l'invention est de conception totalement différente des circuits de l'art antérieur puisque la boucle de régulation du gain effectue un traitement numérique des signaux ce qui permet bien entendu d'avoir les avantages classiques de ce type de traitement mais surtout, de résoudre à la fois le problème de l'intégration et celui de la suppression des effets parasites des modifications du gain lorsque la modification consiste à augmenter le gain et également celui des suroscillations provoquées lors de changements rapides de l'image.

Un multiplieur 1 reçoit sur deux entrées différentielles E₁, E₂ le signal vidéo Vᵢ et le signal Vₙ correspondant au niveau du noir et sur une troisième entrée E₃ le facteur de multiplication qui permet de régler le gain. Le signal de sortie SR pris à la sortie S du multiplieur 1 est appliqué à l'entrée d'un filtre RC 2 qui filtre et lisse le signal vidéo, ce filtre ayant pour cela une fréquence de coupure déterminée de l'ordre de 500 kHz. Ce filtre est réalisable à l'aide d'une capacité intégrée inférieure à 10 pF. Le signal de sortie du filtre est appliqué à l'entrée d'un ensemble de comparateurs. Cet ensemble est formé d'un premier groupe 3 de deux comparateurs 30 et 31 et d'un deuxième groupe 4 de deux comparateurs 40 et 41.

Le premier groupe de comparateurs permet de procéder à la comparaison du signal vidéo V_{c} à deux seuils prédéterminés au-dessus desquels on désire effectuer un réglage du gain, l'un étant plus faible que l'autre pour permettre un réglage fin du gain. Le seuil le plus élevé est constitué par le niveau V_{b} du blanc maximum désiré augmenté d'un niveau d qui est préférentiellement égal à 1,1 dB de la valeur Vb désirée. Le seuil le plus faible est constitué par le niveau du blanc V_{b} augmenté d'un niveau c (c étant inférieur à d) qui est préférentiellement égal à 0,1 dB de la valeur V_{b} désirée.

Le deuxième groupe de comparateurs permet de procéder à la comparaison du signal vidéo V_{c} à deux autres seuils au-dessous desquels on désire effectuer un réglage du gain, l'un étant également plus faible que l'autre de manière à effectuer un réglage plus fin du gain. Le seuil le plus élevé est constitué par le niveau de blanc désiré V_{b} diminué du niveau c qui est préférentiellement égal à 0,1 dB de la valeur V_{b} désirée. Le seuil le plus faible est constitué par le niveau de blanc V_{b} diminué du niveau d qui est préférentiellement égal 1,1 dB de la valeur de V_{b} désirée.

Un circuit d'activation 5 permet à partir des signaux de sortie des comparateurs 30, 31, 40, 41 d'attaquer un circuit de comptage/décomptage 6. La sortie du comparateur 30 active l'entrée de décomptage d'un compteur/décompteur 61 du circuit 6 par l'intermédiaire d'une porte ET 51 du circuit 5, la sortie du comparateur 31 active l'entrée de décomptage d'un compteur/décompteur 62 du circuit 6 par l'intermédiaire d'une porte ET 52 du circuit 5. Les portes 51 et 52 reçoivent sur leur deuxième entrée un signal H dont la fréquence est supérieure à la fréquence trame.

La sortie du comparateur 40 active l'entrée R d'une bascule 53 de type RS du circuit 5. La sortie du comparateur 41 active l'entrée R2 d'une bascule 54 de type RS du circuit 5. Les entrées S1, S2 de ces deux bascules reçoivent un signal IT2 de fréquence égale à la fréquence trame en synchronisme avec la fin du signal retour-trame (front descendant de l'impulsion retour-trame). La sortie Q1 de la bascule 53 est appliquée sur une entrée d'une porte ET 55 dont la sortie attaque l'entrée C2 de comptage du compteur/décompteur 62. La sortie de la porte 56 attaque l'entrée de comptage C1 du compteur-décompteur 61. Les données résultant du comptage ou du décomptage à la sortie de chaque compteur se présentent sous forme de mots de n bits, n étant égal à 4. Les mots de quatre bits correspondant au poids le plus fort p sont appliqués à l'entrée d'un convertisseur numérique/analogique 63. Les mots de quatre bits correspondant au poids le plus faible q sont appliqués à l'entrée d'un convertisseur numérique/analogique 64. Les sorties des convertisseurs 63 et 64 sont appliquées aux entrées d'un additionneur 65 qui permet d'obtenir par addition des signaux de sortie de ces convertisseurs, le signal de réglage du gain au multiplieur 1.

Le fonctionnement du dispositif est le suivant :
Le multiplieur 1 applique le coefficient multiplieur k à la tension Vᵢ - Vₙ reçue sur ses entrées différentielles E1, E2 et délivre une tension k(Vᵢ - Vₙ) à sa sortie S. Le coefficient k est donné par le circuit de comptage 6 et varie en fonction des résultats de comparaison des circuits 3 et 4. Lorsque le signal V_{c} à la sortie de l'intégrateur est inférieur à V_{b} - 1,1 dB les sorties A1 et A2 des comparateurs 40 et 41 sont, par exemple, égales à 0. Si ce n'était pas le cas il suffirait de placer un inverseur devant les entrées R1 et R2 des bascules. Les entrées R1 et R2 des bascules 53 et 54 sont donc à 0, les entrées C1 et C2 des compteurs 61, 62 comptent un coup dès qu'une impulsion IT1 est présente c'est-à-dire dès le début du retour trame. Les convertisseurs 63 et 64 augmentent d'un bit chacun, le gain augmente de p + c soit 1,1 dB (p = 1 dB, c = 0,1 dB) et il reste constant toute la trame suivante.

Lorsque le signal V_{c} est compris entre V_{b} - 1,1 dB et Vb - 0,1 dB, la sortie A1 du comparateur 40 est à 0, la sortie A2 du comparateur 41 est à 1. La bascule 53 ne change pas d'état, tandis que la bascule 54 change d'état, Q1 est égal à 1, Q2 est égal à 0, le compteur 62 compte un coup alors que le compteur 61 ne compte plus, le convertisseur 64 augmente de 1 bit, le gain est augmenté de 0,1 dB.

Lorsque le signal V_{c} est compris entre V_{b} - 0,1 dB et V_{b} + 0,1 dB, la sortie du comparateur 40 passe à 1, la sortie Q1 bascule et passe à 0, les compteurs 61 et 62 ne comptent pas, le gain est inchangé, l'amplitude du signal vidéo se trouve dans une plage de valeurs acceptables.

Lorsque le signal V_{c} est compris entre V_{b} + 0,1 dB, et V_{b} + 1,1 dB, la sortie A2 du comparateur 31 est à 1, la sortie du comparateur 30 est à 0. La porte 52 délivre un 1 à sa sortie dès qu'apparaît une impulsion d'horloge H, le compteur 62 décompte jusqu'à atteindre le gain permettant à l'amplitude du signal de se situer entre V_{b} - 0,1 dB et V_{b} + 0,1 dB.

Lorsque le signal V_{c} est supérieur ou égal à V_{b} + 1,1 dB, la sortie du comparateur 30 est à 1, la sortie du comparateur 31 est également à 1, les compteurs 61 et 62 décomptent un coup à chaque impulsion de l'horloge H. Le gain décroît jusqu'à obtention d'un niveau compris entre V_{b} + 0,1 dB et V_{b} - 0,1 dB.

Le cas d'une sortie Q indéfinie donné par des entrées R et S à 1 ne peut pas se produire car le signal IT2 est à 1 lors de la fin du retour-trame, or à ce moment il n'y a pas de signal de luminance.

Le choix de deux compteurs 4 bits plutôt que d'un compteur 8 bits permet de diminuer l'encombrement car ainsi on peut associer à chaque compteur 4 bits un convertisseur D/A 4 bits, un convertisseur 8 bits étant beaucoup plus encombrement que deux convertisseurs 4 bits.

Le choix des seuils 1,1 dB et 0,1 dB a été fait pour assurer les meilleures conditions de fonctionnement c'est-à-dire pour éviter tout risque d'oscillation de la boucle. Bien entendu, toute autre valeur proche de ces valeurs convient tout à fait.

Le dispositif selon l'invention permet d'effectuer une boucle de réglage numérique du gain d'un signal vidéo par application de ce signal à l'entrée différentielle d'un multiplieur, le coefficient de multiplication qui sert au réglage du gain étant obtenu par un circuit de comptage/décomptage qui permet d'augmenter le gain par incrémentation des compteurs ou de diminuer ce gain par décrémentation des compteurs en fonction des résultats de comparaison obtenus entre ce signal vidéo et un niveau acceptable autour de la valeur du blanc maximum désiré. On choisit des convertisseurs de poids différents sans toutefois aller jusqu'à augmenter le nombre de bits des compteurs et des convertisseurs. Ces poids sont donc choisis de sorte que le contenu maximum du compteur de poids faible (16 × 0,1 dB) ait une valeur supérieure au plus petit poids (1 dB) du compteur de poids fort. On a choisi selon cet exemple particulier un poids p de 1 dB pour le convertisseur 63 et un poids c de 0,1 dB pour le convertisseur 64. Les diminutions de gain se font en synchronisme avec l'horloge H qui est une horloge rapide se situant par exemple entre 50 et 500 kHz. Les augmentations de gain se font en synchronisme avec le signal retour-trame donc pendant le retour-trame ce qui supprime tout risque d'effet parasite sur l'image. La constante de temps pour obtenir une augmentation maximum est de 8 trames soit 160 ms.

## Revendications

1. Dispositif de commande automatique de gain de signaux vidéo, caractérisé en ce qu'il comporte :
- un multiplieur (1) comportant deux entrées différentielles (E1, E2), une première entrée (E1) recevant le signal vidéo (Vᵢ), une deuxième entrée (E2) recevant le signal (Vₙ) correspondant au niveau du noir, et comportant une troisième entrée (E3) pour le réglage du gain, ce multiplieur fournissant un signal vidéo ajusté (V_{c});
- des premiers moyens de comparaison (3) recevant le signal vidéo ajusté (V_{c}), des premier et deuxième seuils obtenus à partir du signal donnant le niveau de blanc désiré (V_{b}) augmenté d'un premier (d) et d'un deuxième (c) niveau ;
- des deuxièmes moyens de comparaison (4) recevant le signal vidéo ajusté (V_{c}), des troisième et quatrième seuils obtenus à partir du signal donnant le niveau de blanc désiré (V_{b}) diminué des premier (d) et deuxième (c) niveaux;
- des moyens d'activation (5) recevant les signaux de sortie des premier (3) et deuxième (4) moyens de comparaison, un signal de retour-trame (IT2) et un signal (H) de fréquence supérieure au signal de retour-trame et délivrant des signaux formés d'impulsions ;
- des moyens de comptage (6) recevant les signaux d'impulsions, ces signaux étant susceptibles de provoquer un comptage d'une quantité proportionnelle au premier ou au deuxième niveau selon le résultat de comparaison et lorsque le signal vidéo ajusté est inférieur aux deux seuils, et de provoquer un décomptage d'une quantité proportionnelle au deuxième ou au premier niveau selon le résultat de comparaison et lorsque le signal vidéo ajusté est supérieur aux deux seuils ; le signal de sortie des moyens de comptage étant reçu à l'entrée de réglage du gain du multiplieur pour provoquer selon la valeur appliquée soit une augmentation du gain pendant les retours-trame, soit une diminution à une fréquence plus élevée.

2. Dispositif de commande automatique de gain selon la revendication 1, caractérisé ce que les premiers moyens de comparaison (3) comportent un premier comparateur (30) procédant à une comparaison entre le signal vidéo ajusté (V_{c}) et le niveau de blanc désiré augmenté du premier niveau (d) et un deuxième comparateur (31) procédant à une comparaison entre le signal vidéo ajusté (V_{c}) et le niveau de blanc augmenté du deuxième niveau (c) et en ce que les deuxièmes moyens de comparaison (4) comportent un premier comparateur (40) procédant à une comparaison entre le signal vidéo ajusté (V_{c}) et le niveau du blanc diminué du deuxième niveau (c) et un deuxième comparateur (41) procédant à une comparaison entre le signal vidéo ajusté et la valeur du blanc diminuée du premier niveau (d).

3. Dispositif selon la revendication 2, caractérisé en ce que les moyens d'activation comportent une bascule (53) dont l'entrée R reçoit le signal de sortie du premier comparateur (40) des deuxièmes moyens (4) dont l'entrée S reçoit le signal de fin de retour-trame (IT2) et dont la sortie est reliée à l'entrée d'une porte ET (55) qui reçoit sur une deuxième entrée le signal de début de retour-trame (IT1), une deuxième bascule (54) dont l'entrée R reçoit le signal de sortie du comparateur (41), dont l'entrée S reçoit le signal de fin de retour-trame (IT2) et dont la sortie Q est reliée à une entrée d'une deuxième porte ET (56) qui reçoit à une deuxième entrée le signal de début de retour-trame (IT1) et en ce qu'une porte ET (51) reçoit à une entrée le signal de sortie du premier comparateur (30) des premiers moyens (3), et une porte ET (52) reçoit à une entrée le signal de sortie du deuxième comparateur (31) des premiers moyens (3), les deuxièmes entrées de ces deux portes recevant le signal d'horloge H.

4. Dispositif de commande automatique de gain selon l'une quelconque des revendications 1 à 3, caractérisé en ce que les moyens de comptage comportent un premier compteur (61) et un deuxième compteur (62), dont les entrées de comptage et de décomptage sont activées par le circuit d'activation (5), un premier convertisseur numérique/analogique (63) de poids p, un deuxième convertisseur numérique/analogique (64) de poids c recevant respectivement les données de comptage du premier compteur et du deuxième compteur, les sorties de ces deux convertisseurs étant appliquées à un additionneur (65) dont la sortie est reliée à la troisième entrée du multiplieur (1) pour le réglage du gain.

5. Dispositif de commande automatique de gain selon les revendications 3 et 4, caractérisé en ce que la sortie du premier comparateur (30) des premiers moyens (3) via la porte ET (51) attaque l'entrée de décomptage du premier compteur (61), la sortie du deuxième comparateur (31) de ces premiers moyens via la porte ET (52) attaque l'entrée de décomptage du deuxième compteur (62), en ce que la sortie du premier comparateur (40) des deuxièmes moyens (4), via la bascule (53) et la porte ET (55), attaque l'entrée de comptage du deuxième compteur (62) et en ce que la sortie du deuxième comparateur (41) des deuxièmes moyens via la bascule (54) et la porte ET (56) attaque l'entrée de comptage du premier compteur (61).

6. Dispositif selon l'une quelconque des revendications 1 à 5, caractérisé en ce qu'il comporte un filtre (2) connecté entre la sortie du multiplieur (1) et l'entrée des premiers et deuxièmes moyens de comparaison et dont la fréquence de coupure est de 500 kHz.

## Claims

1. An automatic gain control device for video signals characterized in this that it comprises:
- a multiplier (1) comprising two differential inputs (E1, E2), a first input (E1) receiving the video signal (Vᵢ), a second input (E2) receiving the signal (Vₙ) corresponding to the black level, and comprising a third input (E3) for the gain setting, said multiplier providing an adjusted video signal (V_{c});
- first comparison means (3) receiving the adjusted video signal (V_{c}), first and second thresholds obtained from the signal providing the desired white level (V_{b}) increased with first (d) and second (c) levels;
- second comparison means (4) receiving the adjusted video signal (V_{c}), third and fourth thresholds obtained from the signal providing the desired white level (V_{b}) decreased by the first (d) and second (c) levels;
- driving means (5) receiving the output signals from the first (3) and second (4) comparison means, a frame return trace signal (IT2) and a signal (H) having a frequency higher than the frame return trace signal and providing pulse signals;
- counting means (6) receiving the pulse signals, said signals being able to cause a count of a quantity proportional to the first or second level according to the comparison result and when the adjusted video signal is lower than the two thresholds, and to cause a count-down of a quantity proportional to the second or third level according to the comparison results and when the adjusted video signal is higher than the two thresholds; the output signal of the counting means being received on the gain setting input of the multiplier for causing, according to the applied value either a gain increase during frame return traces, or a decrease at an higher frequency.

2. An automatic gain control device according to claim 1, characterized in this that the first comparison means (3) comprise a first comparator (30) comparing the adjusted video signal (V_{c}) with the desired white level increased by said first level (d) and a second comparator (31) comparing the adjusted video signal (V_{c}) with the white level increased by said second level (c), and that the second comparison means (4) comprise a first comparator (40) comparing the adjusted video signal (V_{c}) with the white level decreased by the second level (c) and a second comparator (41) comparing the adjusted video signal with the white level value decreased by the first level (d).

3. An automatic gain control device according to claim 2, characterized in this that said driving means comprise a flip-flop (53), the input R of which receives the output signal from the first comparator (40) of the second comparison means (4), the S input of which receives the frame return trace end signal (IT2) and the output of which is connected with the input of an AND gate (55) which receives on a second input the frame return beginning signal (IT1), a second flip-flop (54), the R input of which receives the output signal from the second comparator (41) of the second comparison means (4), the S input of which receives the frame return trace and signal (IT2) and the Q output of which is connected with an input of a second AND gate (56) which receives at a second input the frame return beginning signal (IT1), and that an AND gate (51) receives at an input the output signal from the first comparator (30) of the first means (3) and an AND gate (52) receives on one input the output signal from the second comparator (31) of the first means (3), the second inputs of said two gates receiving the clock signal H.

4. An automatic gain control device according to any of claims 1 to 3, characterized in this that the counting means comprise a first counter (61) and a second counter (62), the up and down counting inputs of which are driven by the driving circuit (5), a first DAC (63) having a weight p, a second DAC (64) having a weight c, respectively receiving the counting data from the first and second counters, the outputs of said two converters being applied to an adder (65), the output of which is connected with the third input of multiplier (1) for setting the gain thereof.

5. An automatic gain control device according to claims 3 and 4, characterized in this that the output of the first comparator (30) of the first means (3) via the AND gate (51) drives the down-counting input of the first counter (61), the output of the second comparator (31) of said first means via the AND gate (52) drives the down-counting input of the second counter (62), the output of the first comparator (40) of said second means (4) via a flip-flop (53) and via an AND gate (55) drives the counting input of the second counter (62) and wherein the output of the second comparator (41) and the second means via a flip-flop (54) and an AND gate (56) drives the up-counting input of the first counter (61).

6. An automatic gain control device according to claim 1 further comprising a filter (2) connected between the output of the multiplier (1) and the input of first and second comparison means and having a cut-off frequency of 500 KHz.

## Patentansprüche

1. Automatische Verstärkungsregelungseinrichtung für Videosignale, gekennzeichnet durch folgende Merkmale:
- einen Verstärker (1) mit zwei Differenzeingängen (E1, E2), von denen ein erster Eingang (E1) das Videosignal (Vᵢ) und ein zweiter Eingang (E2) ein dem Schwarzwert entsprechendes Signal (Vₙ) empfängt, und mit einem dritten Eingang (E3) zur Verstärkungsregelung, wobei dieser Verstärker ein justiertes Videosignal (V_{c}) abgibt;
- eine erste Vergleichsschaltung (3), die das justierte Videosignal (V_{c}) sowie erste und zweite Schwellensignale empfängt, die aus dem den gewünschten Weißwert angebenden Signal (V_{b}) durch Erhöhen um einen ersten (d) bzw. zweiten Pegel (c) erhalten werden;
- eine zweite Vergleichsschaltung (4), die das justierte Videosignal (V_{c}) sowie dritte und vierte Schwellensignale empfängt, die aus dem den gewünschten Weißwert angebenden Signal (V_{b}) durch Erniedrigen um einen ersten (d) bzw. zweiten Pegel (c) erhalten werden;
- eine Aktivierungsschaltung (5), die die Ausgangssignale der ersten und zweiten Vergleichsschaltung (3, 4), ein Bildrücklaufsignal (IT2) und ein Signal (H) mit einer Frequenz größer der des Bildrücklaufsignales empfängt und Impulssignale abgibt;
- eine Zählschaltung (6), die die Impulssignale empfängt, wobei diese Signale ein Zählen einer Menge proportional dem ersten oder zweiten Pegel entsprechend dem Vergleichsergebnis auslösen, wenn das justierte Videosignal unter den beiden Schwellen liegt, bzw. ein Abwärtszählen einer Menge proportional dem zweiten oder dem ersten Pegel auslösen, wenn das justierte Videosignal über den beiden Schwellen liegt; wobei das Ausgangssignal der Zählschaltung am Eingang zur Verstärkungsregelung der Verstärkers empfangen wird, um entsprechend dem angelegten Wert entweder eine Erhöhung der Verstärkung während des Bildrücklaufsignales oder eine Verringerung bei erhöhter Frequenz zu verursachen.

2. Automatische Verstärkungsregelungseinrichtung nach Anspruch 1, dadurch gekennzeichnet, daß die erste Vergleichsschaltung (3) einen ersten Komparator (30), der einen Vergleich zwischen dem justierten Videosignal (V_{c}) und dem gewünschten Weißwert, erhöht um den ersten Pegel, ausführt, und einen zweiten Vergleicher (31) aufweist, der einen Vergleich zwischen dem justierten Videosignal (V_{c}) und dem Weißwert, erhöht um den zweiten Pegel, ausführt, und daß die zweite Vergleichsschaltung (4) einen ersten Komparator (40), der einen Vergleich zwischen dem justierten Videosignal (V_{c}) und dem gewünschten Weißwert, verringert um den zweiten Pegel (c), ausführt, und einen zweiten Vergleicher (41) aufweist, der einen Vergleich zwischen dem justierten Videosignal (V_{c}) und dem Weißwert, verringert um den ersten Pegel (d), ausführt.

3. Einrichtung nach Anspruch 2, dadurch gekennzeichnet,daß die Aktivierungsschaltung aufweist
- ein Flip-Flop (53) , dessen R-Eingang das Ausgangssignal des ersten Komparators (40) der zweiten Vergleichsschaltung (4) und dessen S-Eingang das Bildrücklauf-Endesignal (IT2) empfängt und dessen Ausgang mit dem Eingang eines UND-Tores (55) verbunden ist, das an seinem zweiten Eingang das Bildrücklauf-Anfangssignal (IT1) empfängt,
- ein zweites Flip-Flop (54), dessen R-Eingang das Ausgangssignal des Komparators (41) und dessen S-Eingang das Bildrücklauf-Endesignal (IT2) empfängt und dessen Ausgang Q mit einem Eingang eines zweiten UND-Tores (56) verbunden ist, das an seinem zweiten Eingang das Bildrücklauf-Anfangssignal (IT1) empfängt,
und daß ein UND-Tor (51) an einem Eingang das Ausgangssignal des ersten Komparators (30) der ersten Vergleichsschaltung (3) und ein UND-Tor (52) an einem Eingang das Ausgangssignal des zweiten Komparators (31) der ersten Vergleichsschaltung (3) empfängt, wobei die jeweils zweiten Eingänge der beiden Tore das Taktsignal H empfangen.

4. Automatische Verstärkungsregelungseinrichtung nach einem der Ansprüche 1 bis 3, dadurch gekennzeichnet, daß die Zählschaltung einen ersten Zähler (61) und einen zweiten Zähler (62) aufweist, deren Aufwärts- und Abwärtszähleingänge durch die Aktivierungsschaltung (5) aktiviert werden, sowie einen ersten Digital/Analog-Wandler (63) mit dem Gewicht p und einen zweiten Digital/Analog-Wandler (64) mit dem Gewicht c aufweist, wobei die Ausgänge der beiden Wandler einem Addierer (65) zugeführt sind, dessen Ausgang mit dem dritten Eingang des Verstärkers (1) zur Regelung der Verstärkung verbunden ist.

5. Automatische Verstärkungsregelungseinrichtung nach Anspruch 3 oder 4, dadurch gekennzeichnet, daß der Ausgang des ersten Komparators (30) der ersten Vergleichsschaltung (3) über das UND-Tor (51) mit dem Abwärts-Zähleingang des ersten Zählers (61) und der Ausgang des zweiten Komparators (31) der ersten Vergleichsschaltung über das UND-Tor (52) mit dem Abwärts-Zähleingang des zweiten Zählers (62) verbunden ist, daß der Ausgang des ersten Komparators (40) der zweiten Vergleichsschaltung (4) über das Flip-Flop (53) und das UND-Tor (55) mit dem Aufwärts-Zähleingang des zweiten Zählers (62) verbunden ist, und daß der Ausgang des zweiten Komparators (41) der zweiten Vergleichsschaltung über das Flip-Flop (54) und das UND-Tor (56) mit dem Aufwärts-Zähleingang des ersten Zählers (61) verbunden ist.

6. Einrichtung nach einem der Ansprüche 1 bis 5, dadurch gekennzeichnet, daß sie einen Filter (2) aufweist, der zwischen den Ausgang des Verstärkers (1) und den Eingang der ersten und zweiten Vergleichsschaltung geschaltet ist und dessen Grenzfrequenz 500 kHz ist.
